## Europäisches Patentamt
### European Patent Office
### Office européen des brevets

(19)

(11) Publication number: **0 124 265**
**B1**

(12) **EUROPEAN PATENT SPECIFICATION**

(45) Date of publication of patent specification: **07.10.87**

(51) Int. Cl.⁴: **G 03 F 7/08**

(21) Application number: **84302145.2**

(22) Date of filing: **29.03.84**

(54) **Process for forming pattern with negative resist.**

(30) Priority: **31.03.83 JP 53673/83**
**02.05.83 JP 76203/83**
**23.08.83 JP 153818/83**
**23.08.83 JP 153819/83**
**06.09.83 JP 163871/83**
**19.12.83 JP 239295/83**
**19.12.83 JP 239296/83**

(43) Date of publication of application:
**07.11.84 Bulletin 84/45**

(45) Publication of the grant of the patent:
**07.10.87 Bulletin 87/41**

(84) Designated Contracting States:
**DE FR GB**

(56) References cited:
**PATENTS ABSTRACTS OF JAPAN, vol. 5, no. 161 (P-84)833r, 16th October 1981**

**PATENTS ABSTRACTS OF JAPAN, vol. 5, no. 150 (P-81)822r, 22nd September 1981**

(73) Proprietor: **Oki Electric Industry Company, Limited**
**7-12, Toranomon 1-chome Minato-ku**
**Tokyo 105 (JP)**

(72) Inventor: **Yamashita, Yoshio Oki Electric Industry Co. Ltd.**
**7-12 Toranomon 1-chome Minato-ku**
**Tokyo (JP)**
Inventor: **Kawazu, Ryuji Oki Electric Industry Co. Ltd.**
**7-12 Toranomon 1-chome Minato-ku**
**Tokyo (JP)**

(74) Representative: **Crawford, Andrew Birkby et al A.A. THORNTON & CO. Northumberland House 303-306 High Holborn London WC1V 7LE (GB)**

(56) References cited:
**J. ELECTROCHEM. SOC. SOLID STATE SCIENCE & TECHNOLOGY, vol. 126, no. 5, May 1979, pages 860-864, Princeton, N.Y., US; H. HIRAOKA et al.: "Electron beam-induced reactions of orthonaphthoquinone-diazide-sulfonyl derivatives in phenolic-type resins"**

Courier Press, Leamington Spa, England.

**0 124 265**

(56) References cited:
**J. ELECTROCHEM. SOC.: SOLID STATE SCIENCE, vol. 117, no. 12, December 1970, pages 1555-1556, Princeton, N.Y. US; B. BROYDE. "Exposure of photoresists. II. Electron and light exposure of a positive photoresist"**

**IBM TECHNICAL DISCLOSURE BULLETIN, vol. 19, no. 4, September 1976, page 1216, New York, US; C.A. CORTELLINO: "Noncracking developers"**

**PATENTS ABSTRACTS OF JAPAN, vol. 5, no. 142 (P-79)814r, 8th September 1981**
**PATENTS ABSTRACTS OF JAPAN, vol. 6, no. 206 (P-149)1084r, 19th October 1982**

## Description

The present invention is concerned with a process for making patterned substrates which are suitable for use in semiconductors, magnetic bubble elements, and other components.

Recently, there have been increasingly severe demands for highly integrated semiconductor circuits and the like so that radiations having shorter wavelengths than that conventionally used (particularly, ultraviolet rays), such as electron beam, X-rays, far ultraviolet radiation or the like, have been used in lithography instead of such conventional light.

In particular, the lithographic technique in which far ultraviolet radiation is used is not only an extension of conventional photolithography, but also a technique by which submicron transfer becomes easily possible. Extensive use of this lithographic technique may therefore be expected in future fine working. These methods of fine working may be classified into the etching method and the lift-off method.

In the lift-off method, severe conditions such as a suitable resist film profile, thermal resistance, solubility, adhesive properties and the like are required in the resist which is used. More specifically, it is necessary for easy pattern formation using the lift-off method that a layer applied to the resist film can be easily removed together with the resist. For this reason, it is desirable that the profile of the resist film of the pattern should have an overhung form.

In order to obtain such an overhung form, either a multi-layer resist construction is used or a positive type photoresist such as AZ—1350J (trade name of photoresist manufactured by Shipley Co.) is treated with chlorobenzene. However, these methods are complicated and have inferior throughput and poor reproducibility.

Japanese Patent 56—92536 describes a pattern formation method using a positive quinonediazide resist film which is selectively exposed to far ultraviolet radiation having a wavelength of from 180 to 300 nm, heated at from 80 to 100°C for from 15 to 20 minutes to insolubilise the exposed areas, then uniformly irradiated with ultraviolet light having a wavelength of 7,350 nm to solubilise those areas not previously irradiated and developed in an alkaline or metal-free developing fluid to give a negative pattern.

We have now developed a process for making a patterned substrate using a negative quinonediazide resist film which largely overcomes the drawbacks of the prior art, in particular, the multiple steps of the method of Japanese Patent 56—92536. Thus it has been found that the irradiation of a negative quinonediazide resist film with far ultraviolet light having a wavelength of from 180 to 300 nm followed by development in a solution containing an acetic ester, an alkyl ketone, or cyclohexanone gives a resist pattern of high resolution and sensitivity having improved dry etching resistance and improved thermal resistance. Furthermore, there are no cracks in the resulting resist pattern and its profile has an overhung form of submicron order. Using the process of the invention, resist patterns having excellent throughput and good reproducibility can be obtained by the lift-off method.

According to the present invention, therefore, there is provided a process for making a patterned substrate, which comprises

(a) forming a negative type resist film comprising a quinone diazide sulphonic ester of novolak resin having a degree of polymerisation of not more than 10 on a substrate,

(b) exposing selected areas of the film to far ultraviolet radiation having a wavelength of from 180 to 300 nm, and

(c) developing the exposed film by means of a developer containing an acetic ester, an alkyl ketone, or cyclohexanone to give a patterned substrate.

For a better understanding of the invention, reference will be made in the following description to the accompanying drawings, in which:

Figure 1 is a cross-sectional view showing the irradiation of selected areas of the photoresist through a mask;

Figure 2 is a cross-sectional view showing a resist pattern after development; and

Figure 3 is a graph in which the amount (ml) of methyl alcohol added to a developer is plotted as abscissa and the corresponding moisture content (wt%) is plotted as ordinate.

As indicated, the process of the present invention involves exposing a resist film to far ultraviolet radiation, developing the exposed resist film to form a resist pattern, and, optionally, then irradiating the whole surface of the substrate carrying the resist pattern with ultraviolet light before applying a layer of material to the pattern.

In the present invention, naphthoquinone-1,2-diazide-5-sulfonic ester of novolak resin (hereinafter referred to as "LMR") having a polymerization degree of 10 or less is preferably used as the resist material. The term "quinone diazide group" is used herein to describe any such group which is suitable for use in the resist of the present invention, Typical examples include benzoquinone diazide and naphthoquinone diazide.

LMR has 10 times or higher sensitivity than PMMA with respect to far ultraviolet radiation so that submicron transfer is possible and the resist patterns obtained therefrom have excellent dry etching resistance. Further, no sags are observed in the patterns obtained even at a baking temperature of about 200°C. In addition, an overhung form in the resist patterns can be obtained by using LMR resist material with only developing treatment. In brief, LMR may be used both as a resist for dry etching and as a resist for the lift-off method in far ultraviolet lithography.

As shown in Comparative Example 3 below and the like, the quinone diazide in LMR turns to indene carboxylic acid on exposure to ultraviolet radiation and positive type patterns are formed by the further use of any well-know AZ developer. In this type of light irradiation reaction, however, patterns cannot be obtained even if acetic ester is used as the developer.

In other words, the effect of far ultraviolet radiation quite differs from that of ordinary ultraviolet radiation.

In the present invention, that part of the resist film which is irradiated with far ultraviolet rays undergoes structural change so that the exposed part becomes insoluble in acetic ester or the like and gives a pattern on developing. More specifically, although the resist of the invention is a negative resist, the formation of a pattern does not involve cross-linking so that there is no swelling of the pattern and the resulting pattern exhibits significantly high resolution.

Furthermore, LMR is an oligomer and a low molecular weight thereof also contributes to high resolution of the resulting pattern.

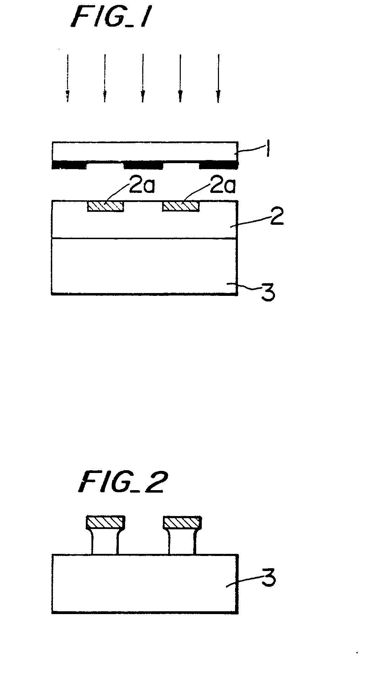

The reason that patterns of overhung form can be obtained by the method of the present invention is that LMR possesses strong absorption in the far ultraviolet region and radiation does not penetrate deeply into the resist so that only the surface becomes insoluble, as shown in Figure 1; upon development of such patterns, the overhung form shown in Figure 2 can be obtained. In Figures 1 and 2, numeral 1 designates a mask, 2 the LMR layer, 3 a substrate, and 2a a reacted region.

On the one hand, LMR is a compound in which the quinone diazide group is combined with novolak by means of a sulphonic acid, and it may be appreciated from, for example, Comparative Example 4 that the structural change is not effected by the reaction of novolak, but is effected by the reaction of the quinone diazide group caused by irradiation with far ultraviolet light. Thus, the polymer used in the present invention must contain a quinone diazide group and also be soluble in acetic ester, alkyl ketone, or cyclohexanone.

When a prescribed amount of water and alcohol is added to the developer, improved patterns without cracks can be obtained.

When a developer containing no water or alcohol is used, it is observed that sometimes cracks tend to appear, particularly on the periphery of a window pattern; the finer the window pattern and the thicker the resist thickness, the more apparent is the formation of cracks.

Since the vapour deposition and the like of metal are adversely affected by such cracks, it is desirable to suppress their formation as much as possible. To achieve such suppression, it might be considered that a thinner thickness of resist would be satisfactory, but such a thin resist is not practical if the thickness of the metal in the metal wiring patterns is taken into consideration. As indicated above, the formation of such cracks can be minimised by adding water and, optionally, alcohol to the developer of the invention. The presence of water in the developer prevents the production of cracks. If only methanol is present, the advantageous effect of preventing the formation of cracks is not achieved.

For example, the developer described in Example 12 shows a low solubility for water so that the saturation content of water in the developer is only 0.46%. The effect of such a water content will be described in more detail in the Example.

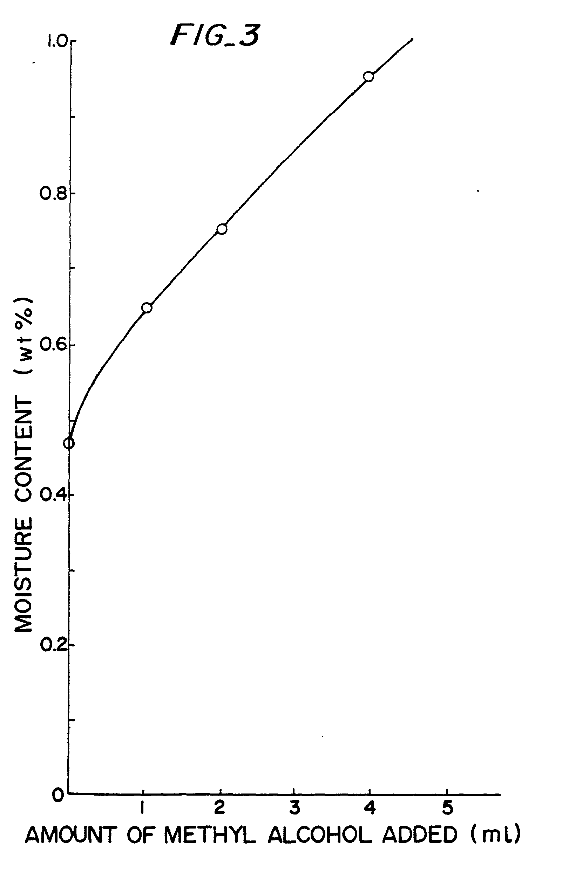

Figure 3 is a graph in which the moisture content in a developer is plotted as ordinate in wt% against the corresponding amount (ml) of methyl alcohol added to the developer plotted as abscissa for the case where 2 ml of water is added to 100 ml of a developer consisting of 10 parts of isoamyl acetate and 2 parts of cyclohexane by volume and methyl alcohol is further added to the resulting mixture. It can be seen from the curve of the graph that when methanol is added to the developer, the moisture content in the developer increases. More specifically, when 4 ml of methanol is added to 100 ml of the developer, the moisture content reaches 0.97% by weight. From this experiment, it may be deduced that when the moisture content in the developer is increased by adding methanol thereto, the formation of cracks can be reduced in a thicker resist film as a result of this increase in the moisture content. It is actually the water which prevents the occurrence of cracks and methanol functions only to increase the moisture content in the developer. For this reason, the alcohol for achieving this result is not limited to methanol as described above; ethanol, isopropanol and the like may alternatively be employed.

In a preferred embodiment of the invention, the resist film is heated at a temperature of from 50 to 120°C prior to development. This results in improvements in the dry etching resistance and the thermal resistance of the resulting resist pattern; furthermore, highly resolved patterns can be formed with high sensitivity using this embodiment.

The improved sensistivity of the final resist pattern as a result of heating is believed to arise from the fact that the reaction does not proceed to 100% final product (insoluble in isoamyl acetate) by irradiation with far ultraviolet rays alone, but the product remains in the state of an intermediate (insoluble in amyl acetate) which is only completely converted to the final product on heating.

The lower temperature limit for the heating step described above is about 50°C, while patterns cannot be obtained using a temperature of more than 130°C. This is because at a temperature of 130°C or more, thermal crosslinking takes place due to decomposition of the quinone diazide group in the LMR so that the LMR becomes insoluble in the developers of the invention. The preferred heating step after exposure is therefore carried out at a temperature of from 50 to 120°C; from 80 to 110°C is particularly preferable.

In the process of the invention, the resist film is optionally first subjected to blanket exposure to ultraviolet radiation having a wavelength of more than 300 nm and is then selectively exposed to far ultraviolet radiation of 300 nm or less using a mask to form a pattern; the exposed resist film is then developed.

As a result of the blanket exposure to ultraviolet radiation, the quinone diazide group is decomposed; the decomposed product exhibits an absorptivity coefficient of 8 $\mu m^{-1}$ at a wavelength of 250 $\mu m$, whereas the absorptivity coefficient of LMR itself, *i.e.* before exposure, is 12 $\mu m^{-1}$ at the same wavelength, *i.e.* the absorptivity of the decomposed product is lower than that of LMR. Hence the transmission of the LMR in the far ultraviolet region is improved by initial blanket ultraviolet irradiation. When selective irradiation is subsequently conducted with far utraviolet radiation through a mask, the radiation penetrates to a deep position in the resist film from the surface so that the film becomes insoluble in the developer. As a result, during development, the overhung amount of the resist pattern is decreased, pattern shortage does not occur, and there is no swelling of the pattern due to development of the decomposed LMR. Thus favourably fine patterns can be obtained, even when the resist film is thick. Moreover, since LMR becomes well soluble in an organic solvent such as acetone or the like after ultraviolet irradiation at a lower wavelength than 300 nm, an inexpensive organic solvent such as acetone may be employed when using the lift-off process.

The amount of exposure to far ultraviolet rays in the present invention is about three times or more than that in which no ultraviolet irradiation is carrried out, but the throughput and the like are not significantly adversely affected by such an amount of exposure.

Another preferred embodiment of the present invention involves subjecting a region to be left as the resist pattern to selective exposure with far ultraviolet radiation at a wavelenth of from 200 to 300 nm, while exposing the region to be removed to ultraviolet radiation having a wave-length of more than 300 nm.

In other words, after formation of an applied layer of the resist film, selective exposure to far ultraviolet and ultraviolet radiation respectively is carried out using reversed patterns and thereafter development is carried out. The treatment is simple, throughput is excellent, and the reproducibility is good.

In another prefered embodiment, the substrate is heated at the time of applying the layer, whereby the adhesion of the resist and the applied layer are improved, with respect to the substrate because of the excellent thermal resistance of the resist material.

The process for forming patterns according to the present invention uses properties whereby the resist is made insoluble (negative) in the developer by means of selective irradiation with far ultraviolet light, and the rate of solution of the resist is accelerated by irradiation with ultraviolet light; light absorption by the resist is noticeable in the far ultraviolet wave-length region so that such light permeates only to an area extending immediately under the surface of the resist, and light reaches the surface of the substrate in the wavelength region of ultraviolet radiation, even when the resist film is thick. Thus, it is apparent that the process of the present invention may be applied using any resist material which exhibits the properties mentioned above, and the same excellent advantages as mentioned above will be attained using such resist materials.

In order that the invention may be more fully understood, the following examples are provided by way of illustration. All solvent ratios given in the examples are by volume.

Example 1

LMR was dissolved in methyl cellosolve acetate and the solution applied to a silicon substrate having a thickness of 0.5 $\mu m$ by the spin coating method. The coated substrate was baked at a temperature of 60°C for 30 minutes and then subjected to contact exposure for 10 seconds using a 500 W Xe-Hg lamp. After exposure, the substrate was developed for 20 seconds using isoamyl acetate to obtain a negative 0.5 $\mu m$ line-and-space resist pattern.

When the resulting resist pattern was observed by means of a scanning type electron microscope (hereinafter referred to as "SEM"), the profile of the resist pattern was found to have an overhung form.

Example 2

The resist pattern obtained in Example 1 was heated at 200°C for 30 minutes and then observed by SEM. No deformation such as sags or the like was observed on the resist pattern, which was the same as observed prior to the heating.

Example 3

LMR was exposed by the method described in Example 1 and the resulting resist pattern was developed for 30 seconds using isoamyl acetate. The pattern obtained was observed by SEM and showed a profile having a larger overhang than that of Example 1.

Example 4

A film of LMR was formed on a substrate by the method described in Example 1 and its dry etching resistance was studied using oxygen plasma. A parallel plate type etching device was used to carry out etching for 15 minutes at 0.08 W/cm² output density, 20 SccM $O_2$ gas flow rate, and 50 pa gas pressure. The resulting amount of etching was 50 nm. For comparison, another etching was carried out under the same conditions but using PMMA; the resulting amount of etching was 200 nm.

Comparative Example 1

LMR was exposed by the method described in Example 1 and developed using AZ-1350J exclusive developer for 60 seconds; no pattern was obtained.

Comparative Example 2

PMMA was applied to silicon substrates having a thickness of 0.5 $\mu m$ and baked at a temperature of 180°C for 30 minutes. The substrates were then exposed using the device described in Example 1 for 60 seconds and 120 seconds, respectively, and were then developed using MIBK. A pattern was obtained in the case of the 120 seconds exposure, but no pattern was obtained from the 60 seconds exposure.

Comparative Example 3
LMR formed by the method described in Example 1 was exposed for 30 seconds using a mask aligner to a 250 W mercury-arc lamp and then developed using AZ-1350J developer to obtain a positive type pattern. In a comparative experiment using isoamyl acetate as the developer, the whole surface of the film dissolved and no pattern was obtained.

Example 5
LMR was exposed by the method described in Example 1 and then developed using methyl isoamyl ketone for 20 seconds. A 0.5 µm resist pattern was obtained.

Example 6
LMR was exposed by the method described in Example 1 and then developed using a 5:2 mixture of n-propyl acetate:cyclohexane. A 0.5 µm resist pattern was obtained.

Example 7
LMR was exposed by the method described in Example 1 and then developed using a 5:1 mixture of isopropyl acetate:isopropyl alcohol. A 0.5 µm resist pattern was obtained.

Comparative Example 4
Novolak resin was dissolved in methyl cellosolve acetate and the solution applied to a substrate having a thickness of 0.5 µm; the coated substrate was then baked at a temperature of 100°C for 30 minutes. Exposure was carried out as described in Example 1 and the substrate was then developed using isoamyl acetate. No pattern was obtained on the substrate.

Example 8
LMR was dissolved in methyl collosolve acetate and the solution filtered using a filter of 0.2 µm and applied to a silicon substrate having a thickness of 0.6 µm to form a resist film. The coated substrate was heated at a temperature of 60°C for 30 minutes and then exposed through a mask in close contact with the resist film to far ultraviolet radiation of from 180 to 300 nm from a 500 W Xe-Hg lamp for 5, 8 and 10 seconds, respectively. The samples were then heated at a temperature of 100°C for 30 minutes and developed for 20 seconds using a 3:2 mixture of cyclohexane:cyclohexanone to give a pattern. It was found that sufficiently resolved 0.5 µm line-and-space patterns could be obtained by this method. Furthermore, it was found that the profile of each resist film forming the pattern had an overhung form.

Example 9
LMR was exposed by the method described in Example 8 except that the thickness of the LMR resist film was 1.2 µm and the exposure time was 10 seconds. After exposure, the coated substrate was heated at a temperature of 100°C for 30 minutes and then developed for 15 seconds using a mixture prepared by adding 0.002 parts of water to a 1:1 mixture of cyclohexanone:cyclohexane to give a pattern. In this way, 0.5 µm space patterns could be obtained. In addition, it was found that no cracks were present in the resist film of the resulting resist pattern.

Example 10
An LMR resist film was formed, heated and exposed by the method described in Example 8, then heated at a temperature of 100°C for 30 minutes and developed for 20 seconds using a 4:2 mixture of isopropyl alcohol:cyclohexanone to give a pattern. In this way, 0.5 µm line-and-space resist patterns could be obtained.

Example 11
The formation, heating, and exposure of an LMR resist film were carried out by the method described in Example 8, except that a naphthoquinone-1,2-diazide-5-sulfonic ester of vinyl phenol having a polymerization degree of 10 or less was used as the resist material and the exposure time was 20 seconds. The substrate was then heated at a temperature of 100°C for 30 minutes and developed for 20 seconds using a 2:1 mixture of cyclohexane:cyclohexanone to give a pattern. In this way, 0.75 µm line-and-space patterns could be obtained.

In Examples 8 to 11, the developing temperature was 23°C.

As shown by these examples, the part of the LMR coating which is irradiated with far ultraviolet rays undergoes a structural change. As a result, the LMR becomes insoluble in a solvent containing cyclohexanone and negative type resist patterns can be obtained. In the present invention, however, the part of the LMR layer which is irradiated with far ultraviolet rays does not completely gel as shown by the fact that the resist pattern is soluble in dimethylformamide.

It has also been shown that when a solvent containing cycolhexanone is used as the developer and is applied to the resist film, the ratio of dissolution rates at an exposed portion and an unexposed portion of the resist film can be set with high precision; furthermore, the exposed portion does not swell. Thus, when resist patterns are obtained using such a developer, resist layers in close proximity to one another do not adhere together and high resolution can be achieved, so that fine working of the resist patterns, of submicron order, is possible.

Example 12
LMR having a polymerization degree of 10 or less was dissolved in methyl cellosolve acetate and the solution applied to a silicon substrate by the spin coating method to give a resist film having a thickness of 2 μm. The coated substrate was heated in a nitrogen atmosphere at a temperature of 60°C for 30 minutes and then exposed for 10 seconds through a mask in close contact with the resist film to far ultraviolet radiation of from 180 to 300 nm from a 500 W Xe-Hg lamp. The resulting sample was then heated in a nitrogen atmosphere at a temperature of 100°C for 30 minutes and developed in a well agitated solution prepared by adding 2 ml of water and 2 ml of methyl alcohol to 100 ml of a 1:5 mixture of cyclohexane:isoamyl acetate. The temperature of the solution was 23°C and the period of development was 15 seconds. Patterns of 0.75 μm, *i.e.* of submicron order, could be obtained having a profile of overhung form; furthermore, the thermal resistance, solubility and adhesive properties of the resulting resist film were improved compared with those of a conventional resist film. It was also found that no cracks were present in the resist film on which the patterns were formed after the development.

Example 13

An LMR resist film was exposed by the method described in Example 12, then heated in a nitrogen atmosphere at a temperature of 100°C for 30 minutes and developed in a well agitated solution prepared by adding 2 ml of water and 3 ml of methyl alcohol to 100 ml of a 3:2 mixture of cyclohexane:cyclohexanone at a temperature of 23°C to give a pattern having 0.5 μm space patterns. The profile of the resulting resist film had an overhung form and no cracks were observed in the film. As in Example 12, the resist film had improved thermal resistance, solubility, and adhesive properties compared with a conventional resist film.

Comparative Example 5

An LMR resist film was exposed by the method described in Example 12 and then heated in a nitrogen atmosphere at a temperature of 100°C for 30 minutes and developed in a well agitated solution prepared by adding 2 ml of water to 100 ml of a 1:5 mixture of cyclohexane:isoamyl acetate at a temperature of 23°C to give a 0.75 μm pattern. Some cracks were present on peripheral portions of the pattern.

Example 14

LMR was dissolved in methyl cellosolve acetate and the solution filtered through a 0.2 μm filter and applied to a silicon substrate having a thickness of 0.6 μm. The coated substrate was heated at a temperature of 60°C for 30 minutes and then exposed through a mask in close contact with the resist film to a 500 W Xe-Hg lamp for 3, 5 and 10 seconds, respectively.

Each sample was then heated at a temperature of 100°C for 30 minutes and developed in isoamyl acetate to which 0.1% of water had been added. All of the samples gave 0.5 μm line-and-space patterns of satisfactory resolution. The profiles of the resist films of the three samples all had overhung forms.

Comparative Example 6

An LMR resist film was exposed by the method described in Example 14 and immediately after the exposure, development was carried out using the developer described in Example 14. A pattern was obtained in the case of the 10 second exposure, but no patterns were obtained from the 3 second and 5 second exposures.

Example 15

An LMR resist film was exposed by the method described in Example 14 and the samples were then heated at temperatures of 50°C and 130°C for 30 minutes; development was carried out using the developer described in Example 14. The samples heated at 50°C could be resolved after 5 second and 10 second exposures, but resolution was unsatisfactory after only a 3 second exposure. In the samples heated at 130°C, none of the films dissolved in the developer and no patterns were obtained.

Example 16

LMR was dissolved in methyl cellosolve acetate and the solution was applied to a silicon substrate having a thickness of 1 μm to give a resist film.

The coated substrate was heated at a temperature of 60°C for 30 minutes and then exposed to blanket irradiation for 60 seconds with ultraviolet light having a wavelength of more than 300 nm, preferably from 350 to 450 nm, which was obtained by filtering out wavelengths of 300 nm and less from the radiation emitted by a 250 W Hg lamp.

The resulting resist film was then selectively exposed so that only the portions of the film to be left as a resist pattern were irradiated through a mask in close contact with the resist film with far ultraviolet light having a wavelength of from 200 to 300 nm from a 5W Xe-Hg lamp.

After the selective exposure, the sample was heated at a temperature of 100°C for 30 minutes and then developed at a temperature of 23°C for 30 seconds in a solution prepared by saturating a 2:1 mixture of isoamyl acetate:cyclohexane with water at a temperature of 23°C. Examination of the resulting resist pattern by SEM showed that 0.5 μm line-and-space as well as 0.5 μm line patterns could be obtained by this method. It was also found that the profile of the resist film forming the pattern had an overhung form.

A layer of material, for example aluminium, was then evaporated by vacuum deposition at a thickness of 1 μm on to the surface of the substrate having the resist pattern. When the substrate with the applied layer was immersed in an organic solvent, for example acetone, complete lift-off was achieved and a 0.5 μm line-and-space pattern of the applied material could be obtained.

Comparative Example 7

The same resist film as in Example 16 was applied and formed on a substrate and the sample was selectively exposed for 10 seconds through a mask in close contact with the resist film to far ultraviolet radiation having a wavelength of from 200 to 300 nm from a 500 W Xe-Hg lamp without the preceding blanket irradiation with ultraviolet light described in Example 16. The sample was then heated as in the above examples at a temperature of 100°C for 30 minutes and developed for 20 seconds in a similar solution to that used in Example 16, *viz.* a solution prepared by saturating a 5:1 mixture of isoamyl acetate:cylohexane with water. Examination of the resulting resist patterns by SEM showed that a 1 μm line-and-space pattern could be obtained by this method, but not a 0.5 μm line-and-space pattern or a 0.5 μm line resist pattern.

Example 17

LMR was dissolved in methyl cellosolve acetate and the solution applied to a silicon substrate having a thickness of 2 μm to give a resist film. The coated substrate was heated at a temperature of 60°C for 30 minutes and then selectively exposed for 5 seconds through a mask to far ultraviolet radiation having a wavelength of from 200 to 300 nm from a 500 W Xe-Hg lamp.

The mask was then removed and, a reverse mask to the earlier one was applied; selective exposure for 60 seconds to ultraviolet radiation having a wavelength of more than 300 nm from an extra-high pressure Hg lamp was then carried out through the reverse mask. In this case, the additional irradiation dose of ultraviolet light improved the solubility of the irradiated regions in the developer used; this irradiation effect with ultraviolet light appeared after irradiation for several seconds and reached saturation after about 60 seconds. Thus, even when such irradiation was continued for a long period of time, such as 5 minutes or 10 minutes, the rates of dissolution in these long-term irradiations were substantially the same as that obtained using a 60 second irradiation, so that neither advantage nor disadvantage from long-term irradiation was observed.

The sample was then heated at a temperature of 100°C for 30 minutes and developed for 60 seconds at a temperature of 23°C in a solution prepared by saturating a 2:1 mixture of isoamyl acetate:cyclohexane with water.

Examination of the resulting resist pattern by SEM showed that the profile of the resist film had the desired overhung form. 0.5 μm line-and-space patterns and 0.5 μm line patterns could be obtained by this method.

Aluminium, for example, was then eveaporated by vacuum deposition at a thickness of 1.5 μm on to the surface of the substrate on which the resist pattern had been formed. The resulting sample was then immersed in an organic solvent, for example, acetone to effect lift-off. Examination of the resulting substrate by SEM showed that lift-off was complete; 0.5 μm line-and-space patterns and 0.5 μm line patterns could be obtained by this method.

Comparative Example 8

The same resist film as in Example 17 was selectively exposed for 5 seconds through a mask to far ultraviolet radiation having a wavelength of from 200 to 300 nm from a 500 W Xe-Hg lamp without the subsequent irradiation through a reverse mask with ultraviolet light from an extra-high pressure Hg lamp described in Example 17. The sample was then heated at a temperature of 100°C for 30 minutes and developed in a solution prepared by saturating a 5:1 mixture of isoamyl acetate:cyclohexane with water.

Examination of the resulting substrate by SEM showed that 1.5 μm line-and-space patterns could be obtained by this method, but resolution of submicron order, in other words, 0.5 μm and 1 μm line-and-space patterns could not be obtained by this method.

Example 18

LMR was dissolved in methyl cellosolve acetate and the solution applied to a silicon substrate having a thickness of 0.7 μm to give a resist film. The coated substrate was heated at a temperature of 60°C for 30 minutes and then exposed for 10 seconds through a mask to far ultraviolet radiation of from 200 to 300 nm from a 500 W Xe-Hg lamp. The sample was then developed for 30 seconds in a 1:0.2:0.001 mixture of isoamyl acetate:cyclohexane:water. 0.5 μm space resist patterns could be obtained by this method; furthermore, the profile of the resist film forming the resist pattern had an overhung form. The sample was then exposed for 2 minutes to blanket irradiation with ultraviolet light having a wavelength of from 350 to 450 nm from a 250 W extra-high pressure Hg lamp (emission from the lamp of 300 nm or less was cut out by means of a lens system). No deformation of patterns as a result of the irradiation was observed. After the irradiation, the substrate was heated at a temperature of 150°C and the material to be applied, for example, nickel which is a hard metal, was evaporated on to the substrate at a thickness of 0.3 μm. Lift-off was then carried out using dimethylformamide; in this way, 0.5 μm width nickel patterns could be obtained.

Comparative Example 9

Pattern formation of a resist film was carried out by the method described in Example 18 and the substrate was then heated as described in Example 18 without carrying out the preliminary blanket ultraviolet irradiation using the Hg lamp nickel vapour deposition was then carried out. The sample was then immersed in dimethylformamide as in Example 18, but the resist did not dissolve and no nickel pattern was obtained.

Comparative Example 10

Pattern formation of a resist film was carried out by the method described in Example 18 and in this case nickel was evaporated onto the substrate and lift off carried out without preliminary ultraviolet irradiation or heating of the substrate. It was found by microscopy that there was exfoliation in the resulting resist film.

Example 18 and Comparative Examples 9 and 10 are further discussed below.

As mentioned earlier, LMR has high resolution with respect to ultraviolet radiation and can provide a profile having an over-hung form. Furthermore, since LMR contains a quinone diazide group, crosslinking occurs when the LMR is heated at a temperature of 130°C or more. In the present invention, however, since the resist film is irradiated with ultraviolet light having a wavelenth of from 350 to 450 nm after the formation of the resist pattern, the quinone diazide group is photochemically decomposed by the ultraviolet radiation so that crosslinking does not occur even if the resist film is heated further. Thus, the resist film dissolves easily in dimethylformamide to achieve lift-off, even though the film has been heated at 150°C.

In Comparative Example 9, since the resist film is not irradiated with ultraviolet light within the wavelength region mentioned above, the quinone diazide group causes crosslinking of the resist when heated at 150°C so that the resist becomes insoluble in dimethylformide; thus lift-off cannot be achieved using such a resist.

Furthermore, in Comparative Example 10, since nickel is evaporated without heating the substrate, the deposited nickel tends to shrink at the time of vacuum depositon to produce stress, whereby the adhesion between the substrate and the resist deteriorates so that the resist exfoliates at the time of vacuum desposition.

Meanwhile, thermal crosslinking of the quinone diazide group in LMR is caused at a temperature of 120°C or more and in the case where the quinone diazide group is subjected to photochemical decomposition by ultraviolet light, the resist dissolves in dimethylformamide even if the resist has been heated at a temperature of 170°C. It was confirmed experimentally, however, that if the temperature rose further, adhesion between the resist film and the substrate became rigid so that the resist hardly exfoliated from the substrate. It was also found that the overhung form of the LMR resist was not damaged by the heat treatment at 170°C. Furthermore, it was experimentally confirmed that the adhesive properties of the resist film with respect to the substrate were improved by heating the substrate, so that there was no fear of invasion by a material to be applied by vacuum deposition into a gap between the resist layer and the substrate at the time of deposition; therefore, beautiful and sharp applied layer patterns can be obtained.

As mentioned above, even if the resist was heated up to 170°C, lift-off was possible, while the adhesion between the resist and the substrate was improved at the same time; the adhesion between the substrate and the material to be applied was also improved by heating the substrate at the time of applying the material.

Using the process of the present invention, high resolution patterns which are excellent in dry etching resistance and thermal resistance can be transferred with high sensitivity by means of far ultraviolet irradiation; furthermore, resist patterns having an overhung profile are formed during development, so that the invention is suitable for making highly compacted semiconductor components and magnetic bubble elements.

## Claims

1. A process for making a patterned substrate which comprises

(a) forming a negative type resist film (2) comprising a quinone diazide sulphonic ester of novolak resin having a degree of polymerisation of not more than 10 on a substrate (3),

(b) exposing selected areas of the film to far ultraviolet radiation having a wavelength of from 180 to 300 nm, and

(c) developing the exposed film by means of a developer containing an acetic ester, an alkyl ketone, or cyclohexanone to give a patterned substrate.

2. A process according to claim 1, in which the developer contains an acetic ester or cyclohexanone, water, and, optionally, an alcohol.

3. A process according to claim 1 or 2, in which substrate is heated at a temperature of from 50 to 120°C prior to step (c).

4. A process according to claim 1, which comprises the additional step of exposing the whole surface of the film to ultraviolet radiation having a wavelength of more than 300 nm prior to step (b).

5. A process according to claim 1, which comprises the additional step of exposing those areas of the film which are not exposed to far ultraviolet radiation of from 200 to 300 nm in step (b) to ultraviolet radiation having a wavelength of more than 300 nm prior to step (c).

6. A process according to claim 1, which comprises the additional steps of exposing the whole surface of the patterned substrate from step (c) to ultraviolet radiation and then applying a layer of material to the pattern.

## Patentansprüche

1. Verfahren zum Erzeugen eines gemusterten Substrats, enthaltend:

(a) Ausbilden eines Negativresistfilms (2) aus einem Chinondiazidsulfoester von Novolakharz eines Polymerisationsgrades von nicht mehr als 10 auf dem Substrat (3),

(b) Bilichten ausgewählter Bereiche des Filmes mit einer weit ultravioletten Strahlung einer Wellenlänge von 180 bis 300 nm, und

(c) Entwickeln des belichteten Films mittels eines Entwicklers, der einen essigsauren Ester, ein Alkylketon oder Cyclohexanon enthält, um das gemusterte Substrat zu ergeben.

2. Verfahren nach Anspruch 1, bei dem der Entwickler einen essigsauren Ester oder Cyclohexanon, Wasser und ggf. einen Alkohol enthält.

3. Verfahren nach Anspruch 1 oder 2, bei dem das Substrat auf eine Temperatur von zwischen 50 und 120°C vor dem Schritt (c) erwärmt wird.

4. Verfahren nach Anspruch 1, enthaltend den zusätzlichen Schritt des Belichtens der gesamten Oberfläche des Films mit einer Ultraviolettstrahlung einer Wellenlänge von mehr als 300 nm vor dem Schritt (b).

5. Verfahren nach Anspruch 1, enthaltend den zusätzlichen Schritt des Belichtens solcher Bereiche des Films, die nicht mit der weit ultravioletten Strahlung von zwischen 200 und 300 nm im Schritt (b) belichtet worden sind, mit einer ultravioletten Strahlung einer Wellenlänge von mehr als 300 nm vor dem Schritt (c).

6. Verfahren nach Anspruch 1, enthaltend den zusätzlichen Schritt des Belichtens der gesamten Oberfläche des gemusterten Substrats vom Schritt (c) mit ultravioletter Strahlung und anschließendes Aufbringen einer Materialschicht auf das Muster.

**Revendications**

1. Un procédé pour la réalisation d'un substrat à motifs consistant

a) à former sur un substrat (3) une pellicule de réserve (2) de type négatif comprenant un ester quinone diazide sulfonique de résine novolac avec un degré de polymérisation non supérieur à 10.

b) à exposer des zones sélectionnées de la pellicule à un rayonnement ultraviolet lointain d'une longueur d'onde de 180 à 300 nm et

c) à développer la pellicule exposée à l'aide d'un révélateur contenant un ester acétique, une alkylcétone ou de la cyclohexanone pour donner un substrat à motifs.

2. Procédé selon la revendication 1, dans lequel le révélateur contient un ester acétique ou de la cyclohexanone, de l'eau et, facultativement, un alcool.

3. Procédé selon la revendication 1 ou 2, dans lequel le substrat est chauffé à une température de 50 à 120°C avant l'étape c).

4. Procédé selon la revendication 1 qui comprend l'étape additionnelle d'exposition de la totalité de la surface de la pellicule à un rayonnement ultraviolet d'une longueur d'onde supérieure à 300 nm avant l'étape b).

5. Procédé selon la revendication 1 qui comprend l'étape additionnelle d'exposition des zones de la pellicule que ne sont pas exposées au rayonnement ultraviolet lointain de 200 à 300 nm dans l'étape b) à un rayonnement ultraviolet d'une longueur d'onde supérieure à 300 nm avant l'étape c).

6. Procédé selon la revendication 1 qui comprend les étapes additionnelles d'exposition de la totalité de la surface du substrat à motifs provenant de l'étape c) à un rayonnement ultraviolet et d'application ensuite d'une couche de matériau sur le motif.

## FIG_1

## FIG_2

FIG_3

AMOUNT OF METHYL ALCOHOL ADDED (ml)